# EUROPÄISCHE PATENTSCHRIFT

(11) **EP 3 227 027 B1**
(45) Veröffentlichungstag und Bekanntmachung des Hinweises auf die Patenterteilung: **02.01.2019**
(21) Anmeldenummer: 15801368.0
(22) Anmeldetag: 19.11.2015
(51) Int. Cl.: B03B 9/06, B02C 7/00, B02C 7/11

(54) **VERFAHREN ZUR AUFBEREITUNG ELEKTRISCHER UND ELEKTRONISCHER BAUTEILE ZUR RÜCKGEWINNUNG VON WERTSTOFFEN**
METHOD FOR THE PREPARATION OF ELECTRICAL AND ELECTRONIC COMPONENTS FOR THE RECOVERY OF VALUABLE SUBSTANCES
PROCÉDÉ DE TRAITEMENT DE COMPOSANTS ÉLECTRIQUES ET ÉLECTRONIQUES POUR LA RÉCUPÉRATION DE MATÉRIAUX

(30) Priorität: 04.12.2014 AT 508832014
(43) Veröffentlichungstag der Anmeldung: 11.10.2017
(73) Patentinhaber: Andritz AG, 8045 Graz (AT)
(72) Erfinder: GABL, Helmuth, 8046 Graz (AT)
(74) Vertreter: Tschinder, Thomas
(86) Internationale Anmeldenummer: PCT/EP2015/077083
(87) Internationale Veröffentlichungsnummer: WO 2016/087220

(56) Entgegenhaltungen:
- EP-A1- 0 623 390
- EP-B1- 0 932 447
- WO-A2-2011/124195
- DE-C1- 19 518 277

## Beschreibung

Den Gegenstand dieser Erfindung bildet ein Verfahren zur Aufbereitung elektrischer und elektronischer Bauteile zur Rückgewinnung von Wertstoffen, wie beispielsweise der in Leiterplatten enthaltenen Metalle. Die elektrischen bzw. elektronischen Bauteile werden dabei mechanisch vorzerkleinert.

Elektronische Geräte sind für die Steuerung mit einer oder mehreren Leiterplatten ausgerüstet. Auf diesen Leiterplatten sind unterschiedlichste Funktionseinheiten aufgebaut. Elektrisch verbunden sind diese Units meist mit Kupferschleifen oder anderen hochwertigen, elektrisch leitenden Metallen. Damit diese Steuereinheiten mechanisch und thermisch möglichst stabil sind, werden die Verbindungsleitungen meist auf ein GFK Bett (GFK = glasfaserverstärkter Kunststoff) gelegt und mittels Harzen verbunden bzw. eingeschmolzen. Als Harze werden häufig Phenolharze und verschiedene Typen von Epoxidharzverbindungen verwendet. Diese Einbettung schützt zudem vor Feuchtigkeit. Das GFK Panel erlaubt neben dem mechanischen Schutz durch den sehr geringen thermischen Ausdehnungskoeffizienten auch eine thermische Stabilität. Neben GFK werden auch Glasvliese oder auch Papierverbunde verwendet.
Teilweise werden für die Leiterplattenherstellung auch Teflon, Keramik oder andere Polymere verwendet.

Viele der elektronischen Geräte sind bereits nach relativ kurzer Zeit nicht mehr für den Gebrauch geeignet und werden verschrottet. Der hierbei anfallende Schrott enthält eine Vielzahl von wertvollen Rohstoffen, deren Rückgewinnung erstrebenswert ist. Als Wertstoffe sind Metalle, wie z.B. Kupfer, Eisen, Zinn, Blei, Gold, Silber und Platin anzusehen. Aber auch die Rückgewinnung von nichtmetallischen Stoffen, wie Glasfasern, ist erstrebenswert.

Eine Aufbereitung von Elektro- und Elektronikschrott ist aber nicht nur aus Gründen der Ressourcenschonung geboten, vielmehr enthalten die elektronischen Bauteile der Geräte eine Reihe von Stoffen, beispielsweise Schwermetalle, die bei einer Deponierung ein Gefährdungspotential darstellen. Auch sind halogenhaltige, flammgehemmte Reststoffe enthalten. Bei einer thermischen Behandlung (Verbrennung) dieser Stoffe besteht die Gefahr der Bildung von Dioxinen und Furanen.

Auch einfach aufgebaute elektrische Geräte (Elektrogeräte) besitzen Wertstoffe, z.B. Kupfer und Eisen oder auch Kunststoff, deren Rückgewinnung anzustreben ist.

Es gibt bereits viele unterschiedliche Verfahren zur Aufbereitung von Schrott aus elektrischen und elektronischen Bauteilen. Alle diese Verfahren versuchen, Reststoffe wie GFK in einer metallarmen Reinheit und Metall in einer reststofffreien Reinheit zurückzugewinnen, dabei kommen insbesondere mechanische Verfahren zum Einsatz.

Beispielsweise beschreibt die DE 41 00 346 A1 ein Verfahren zur mechanischen Aufbereitung von unsortiertem Geräteschrott, bei dem nach einer manuellen Zerlegung der Geräte, die elektrischen und elektronischen Bauteile in mehreren Stufen mechanisch zerkleinert werden und wobei zwischen den Zerkleinerungsstufen spezielle Trennschritte durchgeführt werden.

Die Zerkleinerung findet hier mit Hilfe von Schneidmühlen statt. In ähnlichen Verfahren werden für die Zerkleinerung Doppelwellenschneider, Hammermühlen oder Schredder verwendet. Bei all diesen Zerkleinerungsmethoden kommt es zu einer erheblichen Staubentwicklung, daher müssen derartige Zerkleinerungsaggregate explosionsgeschützt sein. Der anfallende Staub muss meist wegen der Schadstoffgehalte als Sonderabfall entsorgt werden.

Außerdem kommt es durch den Zerkleinerungs- bzw. Mahlprozess zu einer Wärmeentwicklung, durch die die Kunststoff- und Harzanteile schmelzen können. Dadurch werden die Wertstoffe noch inniger mit den Reststoffen verbunden. Die DE 195 18 277 C1 beschreibt ein Verfahren zum Aufbereiten von Schrott aus bestückten Leiterplatten aus Elektro- oder Elektronikgeräten, bei dem die Leiterplatten mechanisch vorzerkleinert werden und danach mittels flüssigen Stickstoff kryogen versprödet und in einer Hammermühle zerkleinert werden. Auch dabei kommt es zu einer erheblichen Staubentwicklung.

Die Trennung der Metalle von den Reststoffen ist bei herkömmlichen Zerkleinerungsverfahren oft unbefriedigend, da insbesondere bei Leiterplatten die Metalle innig mit den Reststoffen verbunden sind.

Die WO 2011/124195 A2 offenbart ein Verfahren zur Aufbereitung von Leiterplattenschrott, bei dem die Bauteile ggf. vorzerkleinert werden und dann einer Extraktion und anschließend einer Schockwellenbehandlung mit durch Hochspannung ausgelösten Schockwellen in fluidem dielektrischen Medium unterzogen.

Der Erfindung liegt daher die Aufgabe zugrunde, ein Verfahren zur Aufbereitung elektrischer und elektronischer Bauteile bereitzustellen, das eine gute Trennung von Wert- und Reststoffen bewirkt, ohne dass es dabei zu großen Staubentwicklungen kommt.

Gelöst wird diese Aufgabe durch ein Verfahren gemäß Patentanspruch 1.

Erfindungsgemäß werden die vorzerkleinerten Bauteile mit einer Flüssigkeit, vorzugsweise Wasser, vermischt und einer Nassvermahlung unterzogen. Unter Nassvermahlung wird hier ein Mahlprozess in Gegenwart einer Flüssigkeit verstanden. Die Flüssigkeits- bzw. Wasserzugabe kann dabei auch direkt ins Mahlaggregat erfolgen. Das Mahlgut kann also nass oder trocken ins Mahlaggregat eingebracht werden, es soll nur spätestens beim Kontakt mit der Mahlgarnitur nass sein, damit Kunststoffanteile nicht aufschmelzen. Erfindungsgemäß wird die Nassvermahlung zwischen sich relativ zueinander bewegenden Mahlplatten durchgeführt, beispielsweise zwischen zwei Mahlscheiben, von denen zumindest eine Mahlscheibe rotiert (Rotor-Stator-Prinzip). Die Mahlscheiben können konzentrisch angeordnete Mahlzähne aufweisen.

Durch die Nassvermahlung und die Kühlwirkung des Wassers gibt es kein Aufschmelzen der Kunststoffanteile und Epoxidharze. Ein Explosionsschutz kann ebenfalls entfallen, da der Prozess staubfrei und im nassen Medium abläuft.

Durchgeführte Versuche mit dem erfindungsgemäßen Verfahren haben gezeigt, dass damit gut trennbare Fraktionen gebildet werden, da die vermahlten Teilchen eine gleichförmigere Größenverteilung aufweisen. Feinststoffe werden kaum gebildet.

Bei Leierplatten werden im Gegensatz zum Trockenaufschluss die Einzelfasern der GFK Struktur fast unbeschädigt freigelegt und Kupferanteile fallen in kugeliger Form an, da es durch die Nassvermahlung zu einer Verkugelung der Metallkomponenten kommt. Diese kugelige Struktur der Metallteile führt zu einer besseren nachfolgenden Abtrennbarkeit der Wertstoffe, beispielsweise am Nasstrenntisch.

Die für die Nassvermahlung verwendete Flüssigkeit kann beim Prozess im Kreis geführt werden und gegebenenfalls nach einer entsprechende Kühlung bzw. Abtrennung von Feinststoffen für Nassvermahlung wiederverwendet werden.

Vorzugsweise werden die elektrischen und elektronischen Bauteile auf eine Größe kleiner 50mm, vorzugsweise kleiner 20 mm, vorzerkleinert. Diese Vorzerkleinerung kann beispielsweise mit einem Querstromzerspaner oder einer Schneidmühle durchgeführt werden.

Da diese Aggregate nur für eine grobe Vorzerkleinerung und nicht für eine Feinzerkleinerung verwendet werden, ist auch hier die Staubentwicklung sehr gering. Bei der Vorzerkleinerung anfallender Staub kann auch durch einen Wassersprühnebel gebunden werden.

Die Mahlkörper bzw. Mahlplatten können aber auch eine Kegel- oder Zylinderform aufweisen. Dabei können beide Mahlkörper rotieren oder ein Mahlkörper kann feststehen. Wichtig ist nur eine Relativbewegung der Mahlkörper zueinander, da der Aufschluss auf Basis der Einbringung von Reibungskräften erfolgt.

Es ist günstig, wenn der Mahlspalt zwischen den beiden Scheiben kleiner als 1 mm, vorzugsweise kleiner als 0,1 mm ist. Dadurch können insbesondere bei Leiterplatten die Kupferlagen vom faserigen GFK gut abgelöst werden und das abgelöste Kupfer wird verkugelt.

Die vorzerkleinerten Bauteile werden vorzugsweise dem Nassmahlaggregat im Zentrum der Mahlscheiben mit Hilfe einer Förderschnecke oder mit Hilfe einer Trägerflüssigkeit, wie Wasser, zugeführt. Der zu vermahlende Stoffstrom bewegt sich dann spiralförmig nach außen.

Nach der Nassvermahlung erfolgt die Abtrennung der Wertstoffe, also in erster Linie der Metalle, beispielsweise mit Hilfe eines Nasstrenntisches, bei dem die Metalle von den Reststoffen, wie Kunststoffe, GFK-Fasern und Harze aufgrund ihrer Dichte, Flugkurve, Oberflächeneigenschaften und Reibhaftung abgetrennt werden. Bei einem Nasstrenntisch handelt es sich um ein nassmechanisch arbeitendes Aggregat zur Dichtetrennung feiner und feinster Anteile. Über eine bewegte, geneigte Platte wird das Mahlgut aufgegeben. Durch einen Querwasserstrom werden die spezifisch leichtesten Partikel, die Leichtfraktion des Trenntisches, in einer Filmströmung quer zur Platte transportiert. Die spezifisch schwereren Partikel werden durch die schnelle Bewegungsumkehr der bewegten Platte und den Kontakt mit der Plattenoberfläche über die Länge des Tisches transportiert und können als Schwerfraktion abgezogen werden. Mit Nasstrenntischen kann auch eine Auftrennung in mehrere Fraktionen erfolgen. Dabei kann das bei Nassvermahlung verwendete Wasser als Trägermaterial für das Nasstrennverfahren verwendet werden. Zur Trennung des Mahlguts kann auch ein Schwimm-Sink-Verfahren oder ein Flotationsverfahren jeweils mit einstellbarer Dichte des Trägermediums verwendet werden.

Das Gemisch kann auch durch eine elektrostatische Trennung in seine stofflichen Komponenten Metalle bzw. Reststoffe getrennt werden. Auch eine Trennung mit Windsichtern ist denkbar, bzw. kann für die Abtrennung der Wertstoffe eine Kombination der oben erwähnten Trennverfahren verwendet werden.

Es ist sinnvoll, wenn nach der Vorzerkleinerung und vor der Nassvermahlung Eisenteile mit Hilfe von Magneten abgetrennt werden.

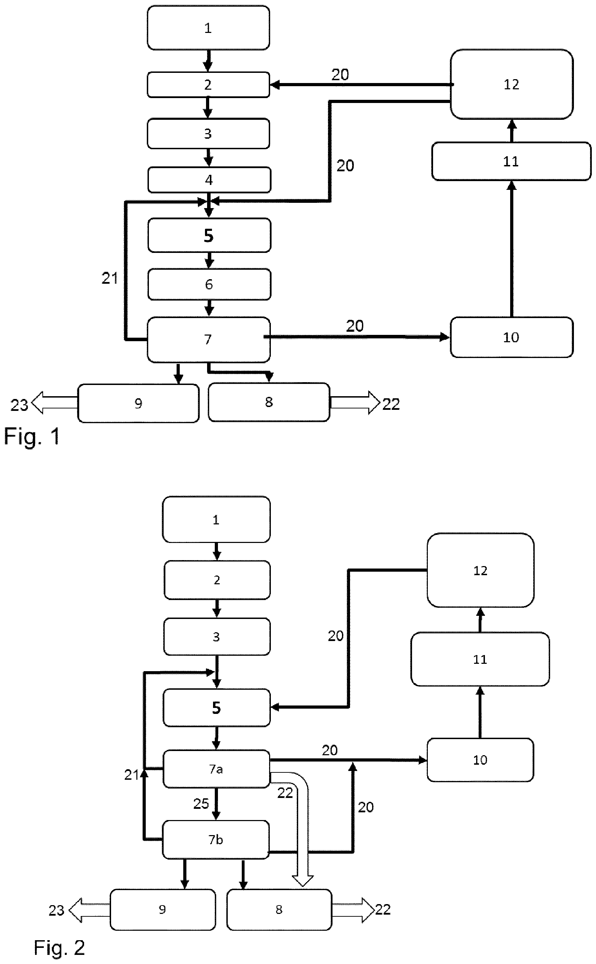

Im Folgenden werden einige Ausführungsbeispiele der Erfindung anhand der Figuren 1 bis 4 beschrieben. Gleiche Bezugszeichen in den jeweiligen Figuren bezeichnen gleiche Bauteile bzw. Stoffströme.

In Figur 1 ist ein einfaches Verfahrensschema des erfindungsgemäßen Aufbereitungsverfahrens dargestellt. Die elektrischen bzw. elektronischen Bauteile werden einem Lager 1 für vorzerkleinertes Gut entnommen und in einer Vorzerkleinerung 2 vorzerkleinert, beispielsweis auf eine Größe kleiner 50 mm. Beim Vorzerkleinerungsaggregat 2 kann es sich beispielsweise um eine Schneidmühle handeln. Zur Unterbindung der Staubentwicklung wird hier Wasser 20 in Form eines Sprühnebels zugeführt und die bei der Zerkleinerung entstehenden Staubpartikel gebunden. Nach der Vorzerkleinerung 2 werden Eisenteile in einem Magnetabscheider 3 abgeschieden und der Materialstrom gesiebt 4, um zu große oder zu kleine Stücke auszuscheiden. Die vorzerkleinerten elektrischen bzw. elektronischen Bauteile werden dann der Nassvermahlung 5 zugeführt und hier zwischen zwei Mahlscheiben nass vermahlen. Über die Wasserzufuhr 20 wird hier der Materialstrom in das Mahlaggregat transportiert. Nach der Nassvermahlung 5 erfolgt eine nochmalige Siebung 6 und eine anschließende Nasstrennung 7 mit einem Nasstrenntisch, bei dem die Wertstoffe 22 und die Reststoffe 23 voneinander getrennt werden und anschließend in einer Trocknung 8 bzw. 9 getrocknet werden.

Die bei der Nasstrennung 7 anfallende Mischfraktion 21 wird wieder der Nassvermahlung 5 zugeführt. Das Wasser 20 der Nasstrennung 7 wird nach der Abscheidung 10 von Feinteilen einer Reinigung 11 und danach einem Wasserspeicher 12 zugeführt. Der Wasserspeicher 12 versorgt die Vorzerkleinerung 2 und die Nassvermahlung 5 mit der notwendigen Flüssigkeit 20.

In Fig. 2 wird die Auftrennung von Reststoffen und Wertstoffen mit zwei Nasstrennschritten 7a und 7b durchgeführt. Die beim ersten Nasstrennschritt 7a anfallenden Wertstoffe 22 werden direkt der Trocknung 8 zugeführt, eine Mischfraktion 21, die sowohl Wertstoffe als auch Reststoffe enthält, wird erneut der Nassvermahlung 5 zugeführt und ein Reststoffstrom 25, der auch Wertstoffe enthält, wird dem zweiten Nasstrenntisch 7b zugeführt. Dort werden die restlichen Wertstoffe 22 von den Reststoffen 23 getrennt und eine Mischfraktion 21 mit unzureichend getrennten Wert- und Reststoffen erneut der Vermahlung 5 zugeführt. Das Wasser 20 aus den beiden Nasstrennschritten 7a und 7b wird wie in Figur 1 beschrieben aufbereitet.

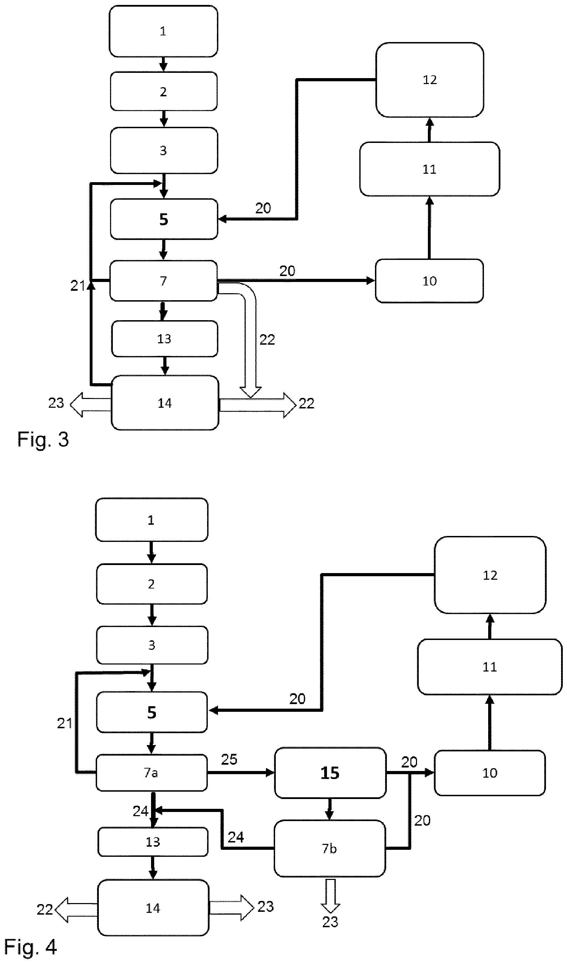

In Figur 3 erfolgt die Auftrennung von Wertstoffen 22 und Reststoffen 23 mit Hilfe eines Nasstrennverfahrens 7 und einer Trockentrennung 14, beispielsweise mit Hilfe eines Windsichters. Vor der Trockentrennung 14 wird das Gemisch einer Trocknung 13 zugeführt. Unzureichend getrenntes Material 21 wird aus der Nasstrennung 7 und aus der Trockentrennung 14 erneut der Nassvermahlung 5 zugeführt. Bereits bei der Nasstrennung 7 anfallende Wertstoffe 22 brauchen nicht mehr der Trockentrennung 14 zugeführt werden.

In Figur 4 werden die vorzerkleinerten Bauteile in einer ersten Nassvermahlung 5 vermahlen und einer ersten Nasstrennung 7a zugeführt. Eine mit Wertstoffen angereicherte Fraktion 24 wird einer Trocknung 13 und einer anschließenden Trockentrennung 14 zugeführt. Die Mischfraktion 21 aus der ersten Nasstrennung 7a wird wieder der ersten Nassvermahlung 5 zugeführt. Die mit Reststoffen angereicherte Fraktion 25 wird in einer zweiten Nassvermahlung 15 nochmals vermahlen und in einer zweiten Nasstrennung 7b in eine mit Wertstoffen angereichte Fraktion 24 und in einen Reststoffstrom 23 aufgetrennt. Die mit Wertstoffen angereichter Fraktion 24 wird der Trocknung 13 und der Trockentrennung 14 zugeführt.

## Patentansprüche

1. Verfahren zur Aufbereitung elektrischer und elektronischer Bauteile zur Rückgewinnung von Wertstoffen (22), wie Metalle, bei dem die Bauteile mechanisch vorzerkleinert werden, wobei die vorzerkleinerten Bauteile mit einer Flüssigkeit (20), vorzugsweise Wasser, vermischt und einer Nassvermahlung (5) unterzogen werden, **dadurch gekennzeichnet, dass** die Nassvermahlung (5) zwischen sich relativ zueinander bewegenden Mahlplatten durchgeführt wird..

2. Verfahren nach Anspruch 1, **dadurch gekennzeichnet, dass** die Bauteile auf eine Größe kleiner 50mm, vorzugsweise kleiner 20 mm, vorzerkleinert werden.

3. Verfahren nach Anspruch 1, **dadurch gekennzeichnet, dass** die Nassvermahlung (5) zwischen zwei Mahlscheiben erfolgt, von denen zumindest eine Mahlscheibe rotiert.

4. Verfahren nach Anspruch 3, **dadurch gekennzeichnet, dass** die Mahlscheiben konzentrisch angeordnete Mahlzähne aufweisen.

5. Verfahren nach Anspruch 3 oder 4, **dadurch gekennzeichnet, dass** der Mahlspalt zwischen den beiden Scheiben kleiner als 1 mm, vorzugsweise kleiner als 0,1 mm ist.

6. Verfahren nach einem der Ansprüche 3 bis 5, **dadurch gekennzeichnet, dass** die vorzerkleinerten Bauteile im Zentrum der Mahlscheiben mit Hilfe einer Förderschnecke mechanisch und/oder mit Hilfe eines flüssigen Trägermediums hydraulisch zugeführt werden.

7. Verfahren nach einem der Ansprüche 1 bis 6, **dadurch gekennzeichnet, dass** nach der Nassvermahlung (5) die Abtrennung der Metalle mit Hilfe eines Nasstrenntisches erfolgt.

8. Verfahren nach Anspruch 7, **dadurch gekennzeichnet, dass** bei der Nassvermahlung (5) verwendetes Wasser als Trägermaterial für den Nasstrenntisch verwendet wird.

9. Verfahren nach einem der Ansprüche 1 bis 8, **dadurch gekennzeichnet, dass** nach der Vorzerkleinerung und vor der Nassvermahlung (5) Eisenteile mit Hilfe von Magneten abgetrennt werden.

## Claims

1. Method for processing electrical and electronic components in order to recover valuable materials (22), such as metals, in which the components are pre-shredded mechanically, where the pre-shredded components are mixed with a liquid (20), preferably water, and then undergo wet milling (5), **characterized in that** wet milling (5) takes place between two milling segments moving in relation to one another.

2. Method according to Claim 1, **characterized in that** the components are pre-shredded to a size smaller than 50 mm, preferably smaller than 20 mm.

3. Method according to Claim 1, **characterized in that** wet milling (5) takes place between two milling discs, at least one of which rotates.

4. Method according to Claim 3, **characterized in that the** milling discs have milling teeth arranged concentrically.

5. Method according to Claim 3 or 4, **characterized in that** the milling gap between the two discs is smaller than 1 mm, preferably smaller than 0.1 mm.

6. Method according to one of Claims 3 to 5, **characterized in that** the pre-shredded components are fed in mechanically at the center of the milling discs with the aid of a screw conveyor and/or hydraulically with the aid of a liquid carrier medium.

7. Method according to one of Claims 1 to 6, **characterized in that** the metals are removed with the aid of a wet separation table after wet milling (5).

8. Method according to Claim 7, **characterized in that** the water used in wet milling (5) is used as carrier material for the wet separation table.

9. Method according to one of Claims 1 to 8, **characterized in that** iron components are removed with magnets after pre-shredding and before wet milling (5).

## Revendications

1. Procédé de traitement de composants électriques et électroniques pour la récupération de matières valorisables (22), telles que des métaux, selon lequel les composants sont préalablement broyés mécaniquement, les composants préalablement broyés étant mélangées à un liquide (20), de préférence à de l'eau, et soumis à un broyage en voie humide (5), **caractérisé en ce que** le broyage en voie humide (5) est effectué entre des plaques de broyage se déplaçant l'une par rapport à l'autre.

2. Procédé selon la revendication 1, **caractérisé en ce que** les composants sont broyés préalablement à une taille inférieure à 50 mm, de préférence inférieure à 20 mm.

3. Procédé selon la revendication 1, **caractérisé en ce que** le broyage en voie humide (5) s'effectue entre deux disques de broyage, parmi lesquels au moins un disque de broyage tourne.

4. Procédé selon la revendication 3, **caractérisé en ce que** les disques de broyage présentent des dents de broyage disposées concentriquement.

5. Procédé selon la revendication 3 ou 4, **caractérisé en ce que** la fente de broyage entre les deux disques est inférieure à 1 mm, de préférence inférieure à 0,1 mm.

6. Procédé selon l'une quelconque des revendications 3 à 5, **caractérisé en ce que** les composants préalablement broyés sont acheminés au centre des disques de broyage mécaniquement à l'aide d'une vis sans fin et/ou hydrauliquement à l'aide d'un matériau porteur liquide.

7. Procédé selon l'une quelconque des revendications 1 à 6, **caractérisé en ce qu'**après le broyage en voie humide (5) la séparation des métaux s'effectue à l'aide d'un plateau de séparation en voie humide.

8. Procédé selon la revendication 7, **caractérisé en ce que** lors du broyage humide (5) l'eau utilisée est utilisée comme matériau porteur pour le plateau de séparation en voie humide.

9. Procédé selon l'une quelconque des revendications précédentes 1 à 8, **caractérisé en ce qu'**après le broyage préalable et avant le broyage en voie humide (5), les débris de fer sont séparés à l'aide d'aimants.
